Europäisches Patentamt

European Patent Office

Office européen des brevets

(11) Numéro de publication: **0 172 949**
**A2**

# (12) DEMANDE DE BREVET EUROPEEN

(21) Numéro de dépôt: **84201793.1**

(22) Date de dépôt: **04.12.84**

(51) Int. Cl.⁴: **H 05 K 3/00**

(30) Priorité: **28.08.84 IT 6785484**

(43) Date de publication de la demande: **05.03.86**
**Bulletin 86/10**

(84) Etats contractants désignés: **BE CH DE FR GB LI NL SE**

(71) Demandeur: **LA ZINCOCELERE S.p.A., Via Jervis 77, I-10015 Ivrea (Torino) (IT)**

(72) Inventeur: **Pinton, Vittorio, Corso Beato Ignazio 81/C, I-13048 Santhia' (Vercelli) (IT)**

(74) Mandataire: **Patrito, Pier Franco, Dr. Ing., Cabinet PATRITO BREVETTI Via Don Minzoni 14, I-10121 Torino (IT)**

(54) Adaptateur pour l'exposition bilatérale de carreaux recouverts par des résines photosensibles.

(57) Un adapteur à appliquer au chassis mobile (6) d'une machine (1) pour l'exposition automatique de carreaux (2) recouverts par des résines photosensibles, comprenant un chassis adaptateur (10) qu'on peut fixer dans le chassis mobile (6) de la machine, et qui forme une saillie inférieure (12) laquelle vient en contact avec la dalle de cristal (4) de la machine lors que le chassis mobile (6) est abaissé, ce chassis adaptateur définant un logement (14) dans lequel on peut insérer avec une certaine mobilité une vitre supérieure (20) à exposer avec le carreau (21), et dont la profondeur est légèrement supérieure à la somme des épaisseurs du carreau (21) à exposer et de deux vitres (20, 22) à exposer avec celui-ci; le chassis adaptateur (10) porte une membrane flexible (24) disposée substantiellement au niveau de la limite supérieure du logement (14), et il présente dans sa surface inférieure au moins un canal (16) s'étendant de l'ouverture d'aspiration (5) de la dalle de cristal (4) jusqu'au logement (14); des moyens de centrement complémentaires (32, 33; 34, 35) sont prévus sur la vitre inférieure (22), sur le carreau (21) à exposer et sur la vitre supérieure (20), afin d'assurer une superposition exactement en registre desdites parties (20, 21, 22).

0172949

## ADAPTATEUR POUR L'EXPOSITION BILATERALE DE CARREAUX
## RECOUVERTS PAR DES RESINES PHOTOSENSIBLES

La présente invention a pour objet un adaptateur à appliquer au chassis mobile d'une machine pour l'exposition automatique de carreaux recouverts par des résines photosensibles.

Certains articles, spécialement des circuits électroniques imprimés, sont fabriqués en imprimant des tracés sur un carreau recouvert par une résine photosensible (telle que le riston ou similaires). Ces tracés sont destinés à des traitements ultérieurs (par esemple de déposition chimique d'une couche métallique, habituellement de cuivre, ou bien d'enlèvement chimique d'une couche de cuivre précédemment laminée), et il sont obtenus par l'exposition à une lumière actinique de la résine photosensible qui recouvre le carreaux, cette exposition étant effectuée à travers une plaque de verre (ou pellicule) portant la reproduction photographique du tracé à réaliser (laquelle plaque ou pellicule, dans la technique considérée, est appelée simplement "vitre", et ainsi sera appelée dans la suite de la présente description). Cette opération est effectuée généralement dans une machine d'exposition automatique expressément réalisée, pourvue d'un tiroir avec un chassis inférieur portant une dalle de cristal sur laquelle on monte la vitre et, en registre sur elle, le carreau, et avec un chassis mobile, articulé au chassis inférieur et soulevable, portant une membrane flexible, généralement de mylar. Dans un coin du chassis inférieur est prévue une ouverture d'aspiration qui traverse la dalle de cristal et permet d'aspirer l'air qui reste emprisonné entre la dalle de cristal et la membrane de mylar suite à l'abaissement du chassis mobile sur le paquet constitué par le carreau à exposer et par la vitre. Ainsi, par l'action de la pression atmosphérique, on assure l'adhésion de la vitre sur le carreau à exposer, afin d'assurer la netteté de l'impression photographique effectuée par contact sur la résine photosensible. Le tiroir avec le chassis inférieur et le chassis mobile est ensuite introduit dans une chambre d'exposition, où il sera soumis, pour un temps préétabli, à l'action d'une source de lumière actinique, tandis que simultanément un deuxième tiroir ayant un chassis inférieur et un chassis mobile sorte de ladite chambre et est présenté à l'opérateur pour en enlever un carreau précédemment exposé et pour y insérer un nouveau carreau à exposer.

Dans les machines considérées, qui sont pourvues de deux sources de lumière actinique, l'une supérieure et l'autre inférieure, il est possible, en théorie, d'exposer simultanément les deux faces d'un carreaux, en disposant sur celui-ci, avant d'abaisser le chassis mobile, une seconde vitre présentant le tracé correspondant. Toutefois, cela présuppose de pouvoir disposer cette plaque de verre ou pellicule supérieure exactement en registre avec le carreau situé au-dessous, ce qui à présent peut être effectué seulement par une opération manuelle, laquelle demande du temps, de l'habilité et de l'attention par l'opérateur, et donne lieu à la possibilité d'erreurs et, de conséquence, à des rebuts, de sorte qu'elle n'est pas bien compatible avec une production industrielle. Pour ces raisons, en pratique on préfère effectuer en des temps successifs l'exposition des deux faces du carreau, ce qui toutefois réduit en mesure considérable la productivité de la machine, en augmentant de conséquence les coûts.

Un autre inconvénient se vérifiant dans cette opération usuelle réside en ce que la membrane de mylar, dont la périphérie est portée par le chassis mobile substantiellement en contact avec la dalle de cristal du chassis inférieur, et dont la partie centrale est maintenue soulevée par le paquet constitué par la vitre et par le carreau à exposer, est considérablement déformée, et elle exerce une traction localisée sur les bords périphériques du carreau, en donnant lieu à une distribution non uniforme de la pression de contact produite par la pression atmosphérique, avec la possibilité conséquente de réduction de la netteté de reproduction (dédoublement de l'image) dans les endroits centraux.

Le but principal de la présente invention est de rendre possible et rentable, en des conditions industrielles, l'exposition simultanée des deux faces des carreaux moyennant les machines automatiques du type référé. Un but ultérieur de l'invention est d'assurer aussi une distribution plus uniforme de la pression de contact entre le carreau à exposer et les vitres appliquées contre celui-ci.

Le but principal susdit est atteint, suivant l'invention, par un adaptateur à appliquer au chassis mobile supérieur d'une machine pour l'exposition automatique de carreaux recouverts par des résines photosensibles, à travers des vitres présentant les tracés à reproduire sur les carreaux, cette machine comprenant au moins un chassis inférieur avec une dalle de cristal ayant une ouverture d'aspiration et un chassis supérieur articulé au chassis inférieur et soulevable par rapport à celui-ci, caractérisé en ce : - qu'il comprend un chassis adaptateur ayant un contour extérieur correspondant à celui dudit chassis mobile, pourvu de moyens pour le montage sur ledit chassis mobile et formant, à l'intérieur dudit chassis mobile, une saillie inférieure telle à porter la surface inférieure du chassis adaptateur en contact avec ladite dalle de cristal lors que le chassis mobile est abaissé; - que ledit chassis adaptateur forme, par son contour intérieur, un logement dont les dimensions correspondent, avec un certain excès, aux dimensions d'une vitre supérieure à exposer avec le carreau, et dont la profondeur, à partir de la surface inférieure du chassis adaptateur, est légèrement plus grande de la somme des épaisseurs d'un carreau à exposer et de deux vitres, l'une inférieure et l'autre supérieure, à exposer avec le carreau; - que ledit chassis adaptateur est pourvu de moyens pour retenir dans ledit logement, avec une certaine mobilité, la vitre supérieure à exposer avec le carreau, ainsi que des moyens pour supporter une membrane flexible (telle qu'une pellicule de mylar) substantiellement à la hauteur de la limite supérieure dudit logement; - que ledit chassis adaptateur est pourvu d'au moins un canal, creusé dans sa surface inférieure, qui s'étend d'une position correspondante à l'ouverture d'aspiration de ladite dalle de cristal jusqu'audit logement; - et qu'ils sont prévus des premiers moyens de centrement complémentaires disposés sur la vitre inférieure et sur le carreau à exposer, et des seconds moyens de centrement complémentaires disposés sur les vitres respectivement inférieure et supérieure et capables d'engager réciproquement lors de l'abaissement du chassis mobile afin d'assurer une superposition exactement en registre desdites vitres.

Grâce à ces dispositions, après avoir monté l'adaptateur selon l'invention sur le chassis mobile de la machine, au lieu de la membrane flexible habituelle, et avoir inséré dans l'adaptateur une vitre supérieure appropriée, la vitre inférieure à exposer peut être fixée sur la dalle de cristal de la machine en une position appropriée, ensuite le carreau à exposer peut être superposé à la vitre inférieure en engageant lesdits premiers moyens de centrement, ainsi assurant la superposition en registre entre carreau et vitre inférieure; le chassis mobile de la machine peut alors être abaissé, en baissant la vitre supérieure sur le carreau et en engageant, comme conséquence de cet abaissement, lesdits seconds moyens de centrement, ainsi assurant, en raison de la mobilité de la vitre supérieure, la superposition en registre desdites deux vitres et donc aussi de la vitre supérieure par rapport au carreau; et enfin on peut effectuer l'aspiration, ainsi provoquant l'application de la membrane flexible, par action de la pression atmosphérique, sur la vitre supérieure, et la compression du paquet constitué par la vitre supérieure, par le carreau et par la vitre inférieure, déposés sur la dalle de cristal. Le tiroir peut alors être introduit dans la chambre de la machine pour l'exposition.

Pourtant, sans ajouter aucune opération à celles nécessaires dans une machine du même type, dépourvue de l'adaptateur selon l'invention, pour exposer le carreau avec la vitre inférieure seulement, on obtient l'application des deux vitres, inférieure et supérieure, en registre sur le carreau et donc la possibilité d'une exposition simultanée correcte des deux faces du carreau, ainsi exploitant complètement les possibilités de la machine d'exposition.

De plus, la membrane flexible est montée à la limite supérieure du logement de l'adaptateur, elle s'applique sur le paquet constitué par le carreau et par les deux vitres sans subir aucune déformation importante, et l'effort appliqué par la pression atmosphérique est uniformément distribué sur le paquet, ainsi réalisant les meilleures conditions d'adhérence entre les parties aux fins de la reproduction nette des tracés.

Lesdites caractéristiques, et autres, et les avantages de l'objet de l'invention ressortiront plus clairement de la suivante description d'un mode de réalisation, constituant un exemple non limitatif, schématiquement représenté dans les dessins annexés, dans lesquels:

Fig. 1 montre schématiquement la construction d'une machine automatique d'exposition destinée à recevoir l'application de l'adaptateur selon l'invention;

Fig. 2 montre en petite échelle l'adaptateur, vu du côté de sa surface inférieure, avec une partie du chassis mobile de la machine et une partie de la vitre supérieure à exposer;

Fig. 3 montre en échelle plus grande une section faite à travers une partie de l'adaptateur, suivant la ligne III-III de la figure 2;

Fig. 4 est une vue de l'une des vitres destinées à être exposées avec le carreau;

Fig. 5 montre en section les moyens complémentaires de centrement entre la vitre inférieure et le carreau, en une forme de réalisation dans laquelle ils servent aussi à centrer une pellicule portant le tracé à reproduire;

Fig. 6 montre en section les moyens complémentaires de centrement entre la vitre inférieure et la vitre supérieure; et

Fig. 7 montre en plan le contour d'une cheville de centrement.

La machine automatique d'exposition du type considéré pour l'application de l'invention comprend une enveloppe 1 définant le bâti de la machine et une chambre d'exposition qui contient les sources de lumière actinique; du côté frontal, à une hauteur commode pour l'opérateur, fait saillie une console 2 ayant des rails latéraux pour le glissement des tiroirs vers l'intérieur et vers l'extérieur de la chambre d'exposition

l. Le tiroir qui est en position extérieure comprend un chassis inférieur 3 avec une dalle de cristal 4, en un coin de laquelle est prévue une ouverture d'aspiration 5. Un chassis mobile 6 (montré, dans la figure l, en position soulevée) est articulé au chassis inférieur 3 et porte une membrane flexible 7. Un tableau installé sur l'enveloppe l présente à l'opérateur les commandes 8 et les instruments 9 de contrôle du fonctionnement.

L'adaptateur comprend un chassis adaptateur substantiellement rectangulaire 10, dont les dimensions externes sont telles à permettre son insertion dans le chassis mobile 6 et son blocage dans le même, par exemple au moyen de vis 11 à tête enfoncée. A' l'intérieur du chassis 6, le chassis adaptateur 10 forme une saillie inférieure 12, grâce à laquelle le chassis adaptateur 10 appuie sur la dalle de cristal 4 de la machine, lors que le chassis mobile 6 est abaissé (figure 3). Une garniture 13 qui entoure la saillie 12 établit l'étanchéité pneumatique qui permet de faire le vide entre le chassis adaptateur 10 et la dalle de cristal 4. Le contour interne 14 du chassis adaptateur 10 définit un logement qui présente, avec excès, les dimensions d'une vitre supérieure 20 destinée à imprimer la face supérieure d'un carreau 21, appuyé sur une vitre inférieure 22, fixée à son tour sur la dalle de cristal 4 moyennant des petites équerres 7, des rubans adhésifs ou d'autres moyens appropriés. L'excès de dimensions du logement 14 est tel à permettre à la vitre supérieure 20 une mobilité, en deux directions, appropriée pour sa mise en registre. Le logement 14 est limité supérieurement par un cadre 18, qui est inséré en un creusement correspondant du chassis adaptateur 10 lelong de son contour interne et qui fait saillie par rapport à ce contour pour constituer un épaulement supérieur d'appui pour la vitre supérieure 20. Le cadre 18 est fixé au chassis adaptateur 10 par des vis 19, et il est monté en serrant entre soi-même et le chassis adaptateur 10 une membrane flexible 24, par exemple de mylar. Une garniture 25 établit l'étanchéité pneumatique de la membrane 24 en la poussant contre le chassis adaptateur 10.

En des endroits appropriés de la surface inférieure du chassis adaptateur 10 sont creusées des cavités 15 dans lesquelles sont logées des lames 26 retenues par des vis 27 et qui peuvent tourner - lors que les vis 27 ne sont pas serrées - entre une position inactive (montrée à la droite dans la figure 2) dans laquelle les lames sont contenues dans les cavités 15, et une position active (montrée dans la figure 3 et a gauche dans la figure 2), dans laquelle les lames font saillie, ainsi retenant par sa partie inférieure la vitre supérieure 20 et la réléguant dans le logement 14 sans toutefois empêcher des déplacements limités de cette vitre dans ledit logement. Pour des raisons de résistance, les lames 26 peuvent opportunément être couplées avec des lames plus courtes 28. Comme on le comprend, cette disposition permet de remplacer facilement la vitre supérieure 20 lors qu'on passe à travailler un carreau différent.

Dans les coins du chassis adaptateur, ou tout au moins dans un de ces coins, dans la surface inférieure du chassis est creusé un canal 16 qui s'étend entre une position correspondante à l'ouverture d'aspiration 3 de la dalle de cristal 4, jusqu'à la chambre centrale définie par le logement 14. Ces canaux autorisent l'aspiration de l'air de ladite chambre centrale et, afin de favoriser sa sortie, ils sont opportunément raccordés à la chambre; pour la même raison, une baisse 17 est prédisposée, de préférence, dans la partie inférieure dudit logement 14. Afin de réaliser une aspiration plus rapide, on peut prévoir nombre d'ouvertures d'aspiration similaires de l'ouverture 5, coopérant avec des différents canaux 16.

La vitre inférieure 22 est pourvue de deux rangs de douilles 30, 31, qui s'étendent suivant deux directions perpendiculaires, ces douilles étant fixées moyennant une résine 29 en des trous correspondants de la vitre 22. Dans une desdites douilles 30, et dans une des douilles 31, choisies en rapport aux dimensions du carreau 21 à exposer, sont insérées des chevilles 32, en regard desquelles des trous 33 sont pratiqués dans le carreau 21. Cette disposition permet une mise en registre rapide, facile et sûre du carreau 21 à exposer, sur la vitre inférieure 22 appliquée sur la dalle de cristal 4. Afin d'éviter des sollicitations nuisibles à la flexion des vitres par la pression atmosphérique, on peut introduire des épaisseurs 39 appropriés dans les espaces laissés libres par le carreau, si celui-ci est de dimensions réduites.

De plus, la vitre inférieure 22 et celle supérieure 20 sont pourvues de deux douilles 34 disposées en des positions correspondantes. Dans les douilles 34 de la vitre inférieure 22 sont insérées des chevilles de centrement 35 ayant une surface supérieure conique 36 d'invitation. Grâce à cette disposition, lors que le chassis mobile 6 de la machine est abaissé sur le chassis fixe 3, les douilles 34 de la vitre supérieure 20 engagent les surfaces coniques d'invitation 36 des chevilles de centrement 35 et font légèrement déplacer la vitre supérieure 20, dont le montage est mobile, en la disposant exactement en registre par rapport à la vitre inférieure 22, après quoi les douilles supérieures 34 peuvent s' insérer sur les chevilles de centrement 35. La vitre supérieure 20 resulte alors automatiquement disposée en registre aussi par rapport au carreau 21. Les opérations de mise en registre des vitres et des carreaux demandent donc seulement la disposition initiale des douilles 30, 31 et 34 et des trous 33 en position correcte par rapport aux tracés à reproduire, et la position de registre ainsi définie est ensuite répétée automatiquement dans le travail en série, avec la précision nécessaire.

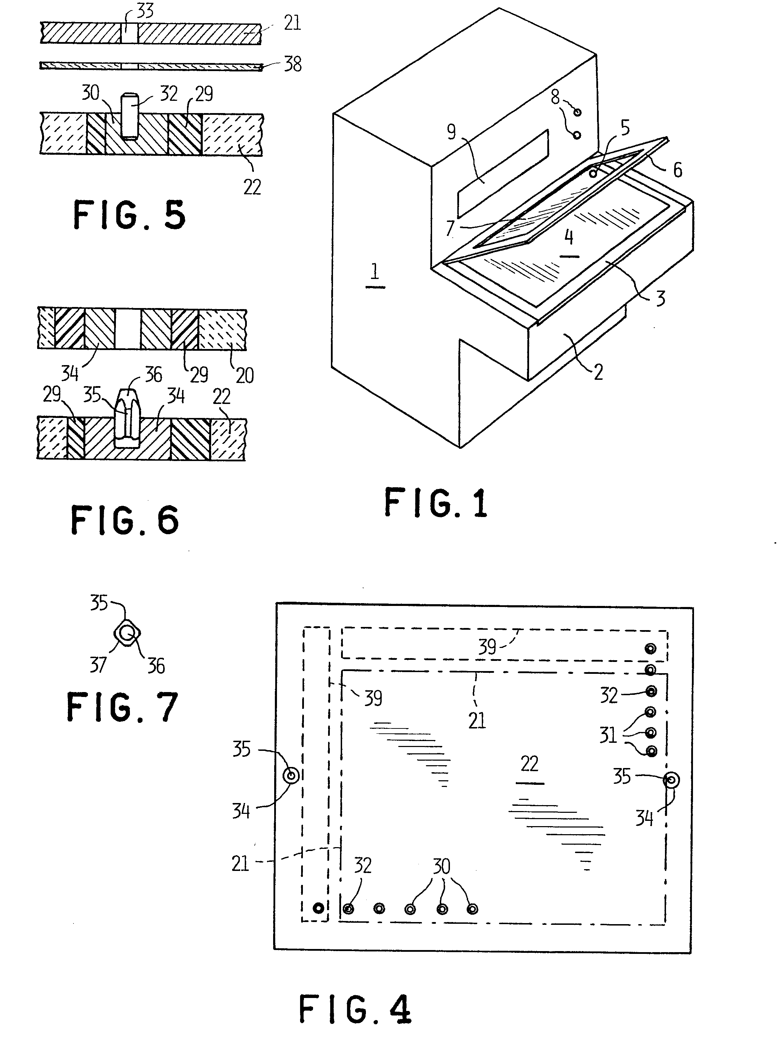

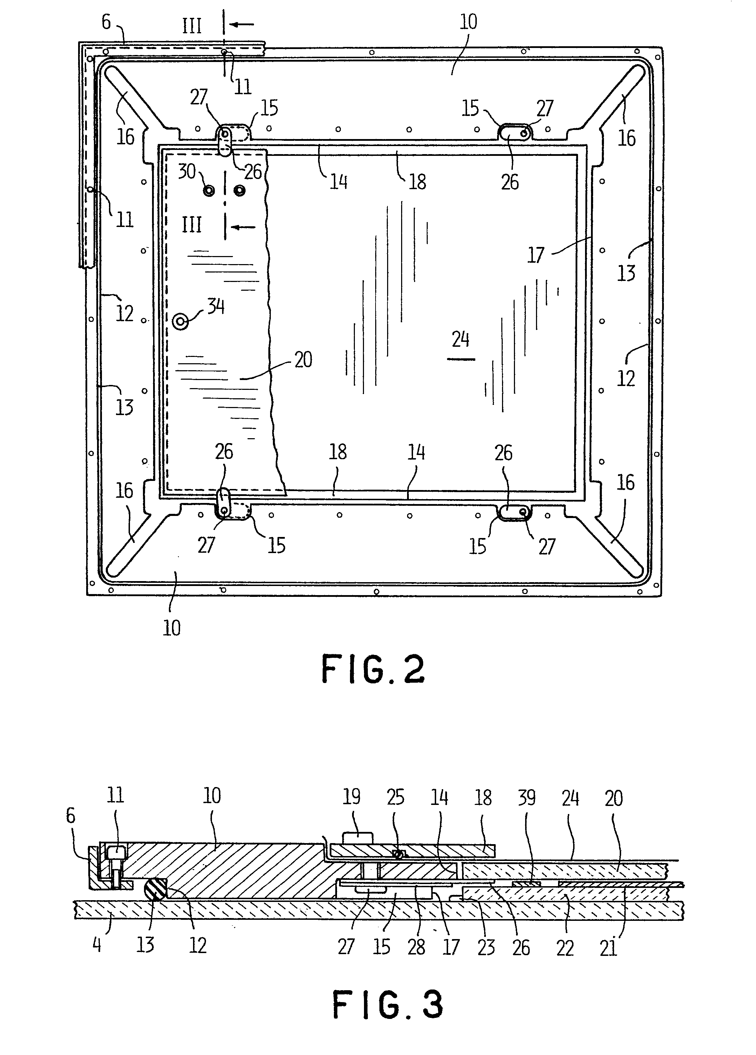

Afin de réduire le frottement des chevilles de centrement 35 dans les douilles supérieures 34, les chevilles peuvent être usinées en enlevant une partie de leur jupe cylindrique, dont restent seulement (par exemple) quatre secteurs, comme il le montre la figure 7.

Pendant l'exposition, les vitres présentant les tracés sont soumis à un certain chauffage. Pour cette raison il a été nécessaire, jusqu'ici, d'employer des plaques photographiques en verre, dont l'émulsion porte l'image des tracés à reproduire. Il n'était pas possible d'employer des films photographiques - bien plus économiques - en raison des déformations excessives que ceux-ci présentent dans lesdites conditions opératives.

Un avantage de l'application de l'invention est d'autoriser la réalisation des tracés à reproduire sur l'émulsion de films photographiques, destinés à être appliqués sur des vitres supérieures 20 et inférieures 22 dépourvues d'images, en réalisant ainsi des économies industrielles importantes. En effet, un film photographique 38 présentant les tracés inférieurs peut être mis en registre sur la vitre inférieure 22 (figure 5) en utilisant les chevilles de centrement 32, et ensuite il peut être fixé à la vitre 22 moyennant des rubans adhésifs disposés lelong de son contour; ce montage sur la vitre inférieure sousjacente donne au film 38, pendant le travail, une stabilité de forme suffisante. D'une façon similaire, un film peut être appliqué à la vitre supérieure 20, si celle-ci est elle aussi pourvue de douilles 30, 31 comme celles décrites pour la vitre inférieure 22, lesquelles peuvent être utilisées pour la mise en registre d'un film supérieur. Dans ce cas, après le fixage périphérique du film à la vitre supérieure, les chevilles de centrement sont retirées des douilles 30 et 31, du moment qu'elle ne doivent pas servir pour la mise en registre du carreau, comme c'est le cas des douilles inférieures.

En raison de ces caractéristiques, les archives des tracés à reproduire se réduisent à des ensembles de films, au lieu qu'à des ensembles de plaques de verre, avec une réduction correspondante des frais, des encombrements et des poids y afférent.

L'application de l'invention permet donc d'outiller une machine automatique normale d'exposition pour carreaux de sorte à permettre une production plus grande, plus rapide et plus économique, avec une qualité plus fiable. La possibilité d'effectuer simultanément l'exposition des deux faces des carreaux est particulièrement intéressante dans le travail des circuits imprimés à deux faces, des couches internes des circuits à plusieurs couches, des circuits à plusieurs couches déjà assemblés, ainsi que de tous autres genres d'objets auxquels cette technique peut être appliquée avec avantage.

- 10 -  0172949

REVENDICATIONS

1 . Adaptateur à appliquer au chassis mobile supérieur (6) d'une machine (1) pour l'exposition automatique de carreaux (21) recouverts par des résines photosensibles, à travers des vitres (20,22) présentant les tracés à reproduire sur les carreaux, cette machine comprenant au moins un chassis inférieur (3) avec une dalle de cristal (4) ayant une ouverture d'aspiration (5) et un chassis supérieur (6) articulé au chassis inférieur (3) et soulevable par rapport à celui-ci, caractérisé en ce :
- qu'il comprend un chassis adaptateur (10) ayant un contour extérieur correspondant à celui dudit chassis mobile (6), pourvu de moyens (11) pour le montage sur ledit chassis mobile et formant, à l'intérieur dudit chassis mobile (6), une saillie inférieure (12) telle à porter la surface inférieure du chassis adaptateur (10) en contact avec ladite dalle de cristal (4) lors que le chassis mobile est abaissé; - que ledit chassis adaptateur (10) forme, par son contour intérieur, un logement (14) dont les dimensions correspondent, avec un certain excès, aux dimensions d'une vitre supérieure (20) à exposer avec le carreau (21), et dont la profondeur, à partir de la surface inférieure du chassis adaptateur, est légèrement plus grande de la somme des épaisseurs d'un carreau (21) à exposer et de deux vitres, l'une inférieure (22) et l'autre supérieure (20), à exposer avec le carreau; - que ledit chassis adaptateur (10) est pourvu de moyens (18,26) pour retenir dans ledit logement (14), avec une certaine mobilité, la vitre supérieure (20) à exposer avec le carreau (21), ainsi que des moyens (18) pour supporter une membrane flexible (telle qu'une pellicule de mylar, 24) substantiellement à la hauteur de la limite supérieure dudit logement (14); - que ledit chassis adaptateur (10) est pourvu d'au moins un canal (16), creusé dans sa surface inférieure, qui s'étend d'une position correspondante à l'ouverture d'aspiration (5) de ladite dalle de cristal (4) jusqu'audit logement (14);
- et qu'ils sont prévus des premiers moyens de centrement complémentaires (32,33) disposés sur la vitre inférieure (22) et sur le carreau (21) à exposer, et des seconds moyens de centrement complémentaires (34,35) disposés sur les vitres respectivement inférieure (22) et supérieure (20) et capables d'engager réciproquement lors de l'abaissement du chassis mobile (6) afin d'assurer une superposition exactement en registre desdites vitres (20,22).

2 . Adaptateur selon la revendication 1, caractérisé en ce que lesdits moyens (18,26) pour retenir la vitre supérieure (20) avec mobilité dans son logement (14) comprennent un cadre (18), monté sur la partie supérieure dudit chassis adaptateur (10) en correspondance de son contour interne, et faisant saillie par rapport audit contour interne pour présenter à la vitre supérieure (20) un épaulement qui en limite la mobilité vers le haut.

3 . Adaptateur selon la revendication 2, caractérisé en ce que ledit cadre (18) serre entre soi-même et le chassis adaptateur (10) ladite membrane flexible (24), disposée sur un plan correspondant à la limite supérieure dudit logement (14).

4 . Adaptateur selon la revendication 1, caractérisé en ce que dans la surface inférieure dudit chassis adaptateur (10) sont creusées des cavités (15) dans lesquelles sont logées des lames (26) déplaçables entre une position dans laquelle elles retiennent du côté inférieur ladite vitre supérieure (20), et une position dans laquelle elles sont retirées dans les logements (15) respectifs, ainsi autorisant le remplacement de la vitre supérieure (20).

5 . Adaptateur selon la revendication 1, caractérisé en ce que ledit chassis adaptateur (10) présente des canaux (16) creusés dans sa surface inférieure en correspondance de plus qu'un coin.

6 . Adaptateur selon la revendication 5, caractérisé en ce que lesdits canaux sont raccordés à une chambre centrale définie par ledit logement (14), et qu'une baisse (17) destinée à favoriser la sortie de l' air aspiré est réalisée dans la partie inférieure de la paroi dudit logement (14).

7 . Adaptateur selon la revendication 1, caractérisé en ce que des

- :2 -                                    0172949

garnitures d'étanchéité (13) sont disposées autour de ladite saillie inférieure (12) du chassis adaptateur (10) et entre ledit cadre (18) e la
membrane flexible (24) qu'il retient.

8 . Adaptateur selon la revendication 1, caractérisé en ce que lesdits premiers moyens de centrement (32,33) comprennent des douilles (30)
insérées au moins dans la vitre inférieure (22) et capables de recevoir
des chevilles de centrement (32) coopérant avec des trous (33) pratiqués
dans le carreau (21) à exposer.

9 . Adaptateur selon la revendication 8, caractérisé en ce que lesdites douilles (30) sont disposées suivant deux rangs perpendiculaires,
lelong de deux côtés de la vitre correspondante (figure 4).

10 . Adaptateur selon la revendication 1, caractérisé en ce que lesdits seconds moyens de centrement (34,35) comprennent deux paires de
douilles (34) insérées en des positions correspondantes des vitres supérieure (20) et inférieure (22), et des chevilles de centrement (35) insérées dans les douilles (34) de la vitre supérieure (20) ou de la vitre
inférieure (22).

11 . Adaptateur selon la revendication 10, caractérisé en ce que
lesdites chevilles de centrement (35) présentent une surface conique
(36) d'invitation destinée à coopérer avec la douille (34) complémentaire pour produire la mise en registre de la vitre supérieure (20) lors de
l'abaissement du chassis mobile (6) de la machine.

12 . Adaptateur selon la revendication 11, caractérisé en ce que
lesdites chevilles de centrement (35) ont une surface cylindrique partiellement enlevée suivant des faces (37) partiellement planes.

13 . Adaptateur selon la revendication 1, caractérisé en ce que
ladite vitre inférieure (22) est dépourvue d'images et porte, entre soi-
-même et le carreau (21) à exposer, un film (38) présentant les tracés à
reproduire, mis en registre par l'emploi desdits premiers moyens de centrement (32,33) et fixé périphériquement à la vitre (22).

14 . Adaptateur selon la revendication 1, caractérisé en ce que
ladite vitre supérieure (20) est elle aussi pourvue de premiers moyens de centrement similaires de ceux (32) de la vitre inférieure (22),, qu' elle est dépourvue d'images et qu'elle porte, entre soi-même et le carreau (21) à exposer, un film présentant les tracés à reproduire, mis en registre par l'emploi desdits premiers moyens de centrement et fixé périphériquement à la vitre (20).

0172949

**FIG. 5**

**FIG. 6**

**FIG. 7**

**FIG. 1**

**FIG. 4**

FIG.2

FIG.3